**Europäisches Patentamt**

**European Patent Office**

**Office européen des brevets**

(19)

(11) Veröffentlichungsnummer: **0 195 315**
**B1**

(12) # EUROPÄISCHE PATENTSCHRIFT

(45) Veröffentlichungstag der Patentschrift:
25.10.89

(51) Int. Cl.⁴: **G 03 F 7/16,** G 03 F 7/26

(21) Anmeldenummer: **86102906.4**

(22) Anmeldetag: **05.03.86**

(54) **Verfahren zum Herstellen von Photoresist-Strukturen.**

(30) Priorität: **11.03.85 US 710561**

(43) Veröffentlichungstag der Anmeldung:
**24.09.86 Patentblatt 86/39**

(45) Bekanntmachung des Hinweises auf die Patenterteilung:
**25.10.89 Patentblatt 89/43**

(84) Benannte Vertragsstaaten:
**AT DE FR GB IT NL**

(56) Entgegenhaltungen:
EP-A-0 021 719
EP-A-0 164 248
EP-A-0 178 594
DE-A-2 461 912
DE-A-3 243 277
GB-A-1 489 167

IBM TECHNICAL DISCLOSURE BULLETIN, Band 13, Nr. 2, Juli 1970, Seite 530, New York, US; L.H. KAPLAN: "Exposure time reduction for positive photoresists"
PHOTOGRAPHIC SCIENCE AND ENGINEERING, Band 21, Nr. 5, September/Oktober 1977, Seiten 290-292, Society of Photographic Scientists and Engineers, Washington, D.C., US; K. JINNO et al.: "Baking characteristics of positive photoresists"
SOLID STATE TECHNOLOGY, Band 26, no. 8, August 1983, Seiten 211-217, Porte Washington,

(73) Patentinhaber: **HOECHST CELANESE CORPORATION, Route 202-206 North, Somerville, N.J. 08876 (US)**

(72) Erfinder: **Spak, Mark A., 11 Lafayette Avenue, Edison, N.J. 08837 (US)**

(74) Vertreter: **Euler, Kurt Emil, Dr., KALLE Niederlassung der Hoechst AG Rheingaustrasse 190 Postfach 3540, D-6200 Wiesbaden 1 (DE)**

(56) Entgegenhaltungen: (Fortsetzung)
**New York, US; T. BATCHELDER et al.: "Bake effects in positive photoresist"**
IBM TECHNICAL DISCLOSURE BULLETIN, Band 24, Nr. 1A, Juni 1981, Seite 8, New York, US; R.J. PERNES et al.: "Baking photoresist to improve adhesion"
IBM TECHNICAL DISCLOSURE BULLETIN, Band 18, Nr. 5, Oktober 1975, Seite 1395, New York, US; B. BERGIN et al.: "Single layer optical lift-off process"

**Beschreibung**

Die vorliegende Erfindung betrifft ein Verfahren zum Herstellen von Photoresist-Strukturen aus positiv arbeitenden Kopiermaterialien, bestehend im wesentlichen aus einem Träger und einem aufgebrachten lichtempfindlichen Gemisch aus wasserunlöslichem, in wäßrig-alkalischen Lösungen löslichem oder zumindest quellbarem Bindemittel, Naphthochinondiazid und Lösemittel, durch Vortrocknen des Gemisches, bildmäßiges Belichten mit aktinischer Strahlung, Ausheizen der belichteten Schicht und Entwickeln.

Die Herstellung positiv arbeitender Photoresistgemische ist bekannt und beispielsweise in den US-A-3 666 473, 4 115 128 und 4 173 470 beschrieben. Dazu gehören alkalische Phenol-Formaldehyd-Novolakharze in Verbindung mit lichtempfindlichen Verbindungen, in der Regel substituierte o-Naphthochinondiazide. Die Harze und lichtempfindlichen Verbindungen werden in einem organischen Lösemittel oder Lösemittelgemisch gelöst und in dünner Schicht auf einen für den jeweiligen Zweck geeigneten Träger aufgetragen.

Die Novolakharzkomponente dieser Photoresistgemische ist in wäßrig-alkalischen Lösungen löslich, doch übt die lichtempfindliche Verbindung auf Naphthochinonbasis eine lösungshemmende Wirkung auf das Harz aus. Bei Belichtung ausgewählter Bereiche des beschichteten Trägers mittels aktinischer Strahlung erfährt die lichtempfindliche Verbindung jedoch eine belichtungsbedingte strukturelle Umwandlung und die Löslichkeit der belichteten Schichtbereiche wird größer als die der unbelichteten Bereiche. Aufgrund dieses unterschiedlichen Löslichkeitsverhaltens werden die belichteten Bereiche der Photoresistschicht beim Eintauchen des Trägers in eine alkalische Entwicklerlösung abgelöst, während die nicht belichteten Bereiche im wesentlichen unverändert erhalten bleiben, so daß auf dem Träger ein positives Reliefbild erhalten wird.

In den meisten Fällen wird der belichtete und entwickelte Träger noch mit einem Ätzmittel behandelt. Die Photoresistschicht schützt die beschichteten Bereiche des Trägers vor dem Ätzmittel, das somit nur auf die schichtfreien Bereiche des Trägers, d. h. im Fall eines positiv arbeitenden Photoresists, auf die mit aktinischer Strahlung belichteten Bereiche, einwirken kann. Auf diese Weise wird auf dem Träger ein Ätzbild erzeugt, das der Maske, Schablone oder sonstigen Vorlage entspricht, durch die der beschichtete Träger vor dem Entwickeln bildmäßig belichtet wurde.

Die nach dem beschriebenen Verfahren auf dem Träger erzeugte Photoresist-Struktur ist für verschiedene Anwendungszwecke geeignet, zum Beispiel bei der Herstellung von Belichtungsmasken oder von Halbleiterbauelementen.

Zu den Kriterien, nach denen die Eignung eines Photoresistgemisches für kommerzielle Zwecke beurteilt wird, zählen die Lichtempfindlichkeit des Resists, der Kontrast nach der Entwicklung, die Resistauflösung, die thermische Stabilität des erzeugten Bildes, der Verarbeitungsspielraum, womit die Wahl der Möglichkeiten in den verschiedenen Verfahrensstufen ausgedrückt ist, die Einhaltung der Linienbreite, saubere Entwicklung, Schichtdickenverlust an nicht belichteten Schichtteilen, usw.

Erhöhte Lichtempfindlichkeit ist für einen Photoresist insbesondere auf solchen Anwendungsgebieten von Bedeutung, wo mehrere Belichtungsvorgänge nötig sind, zum Beispiel bei der mehrfachen Erzeugung eines Bildes durch wiederholte Belichtung (step and repeat Verfahren), oder in Fällen, wo Licht geringerer Intensität verwendet wird, zum Beispiel bei einem Projektionsbelichtungsverfahren, oder Verfahren bei denen das Licht durch eine Reihe von Linsen und monochromatischen Filtern geleitet wird. Erhöhte Lichtempfindlichkeit ist daher von besonderer Bedeutung für Photoresistgemische, die in Verfahren eingesetzt werden, bei denen zur Erzeugung einer Maske oder einer Reihe von Schaltbildern auf einem Träger mehrfach belichtet werden muß. Optimale Entwicklungsbedingungen herrschen, wenn für ein bestimmtes Entwicklungsverfahren stets die gleiche Temperatur und Entwicklungszeit gelten und wenn Entwickler- und Photoresist-gemisch so aufeinander abgestimmt sind, daß die belichteten Photoresistbereiche vollständig entwickelt werden, während die Dicke der Photoresistschicht in den unbelichteten Bereichen möglichst erhalten bleibt, d. h. nicht mehr als 10 % der ursprünglichen Dicke verlorengehen.

Auf den Kontrast beim Entwickeln kann man aus der Neigung des linearen Teils der Kurve schließen, die man erhält, wenn man unter Einhaltung konstanter Entwicklungsbedingungen den Logarithmus der Belichtungsenergie gegen die normierte Schichtdicke aufträgt. In der Praxis wird eine auf einen Träger aufgebrachte Photoresistschicht so lange entwickelt, bis sie praktisch vollständig von den belichteten Bereichen entfernt ist.

Die Resistauflösung betrifft das Vermögen eines Photoresistsystems, auch die feinsten im gleichen Abstand zueinander angeordneten Linienpaare und Zwischenräume auf einer für die Belichtung verwendeten Maske wiederzugeben, wobei die belichteten und entwickelten Bereiche ein hohes Maß an Kantenschärfe aufweisen sollen.

In vielen industriellen Einsatzgebieten, insbesondere bei der Herstellung von Halbleiterbauelementen, muß der eingesetzte Photoresist auch noch bei sehr geringen Linien- und Abstandsbreiten eine hohe Auflösung von 1 µm und weniger ergeben.

Die Fähigkeit eines Photoresists zur Wiedergabe von Bildstellen sehr geringer Abmessungen, in einem Größenbereich von 1 µm oder weniger, ist für die großtechnische Herstellung integrierter Schaltungen auf Siliciumscheiben (Wafer) und ähnlicher Bauteile von entscheidender Bedeutung. Die Integrationsdichte auf einem solchen Chip kann beim Einsatz photolithographischer Verfahren nur durch eine Steigerung des Auflösungsvermögens des Resists erhöht werden.

In der Halbleiterindustrie werden bisher weitgehend negativ arbeitende Photoresists eingesetzt, bei denen die vom Licht getroffenen Stellen der Photoresistschicht unlöslich werden. Die unbelichteten Stellen werden dann vom Entwickler abgelöst. Dagegen besitzen positiv arbeitende Photoresists im allgemeinen ein höheres Auflösungsvermögen, sie ersetzen deshalb die negativ arbeitenden Photoresists in zunehmendem Maß.

Eine Wärmebehandlung nach der Belichtung, auch als "Diffusion Baking" bekannt, ist ein bei der Herstellung integrierter Schaltungen häufig angewendetes Verfahren, um das Auftreten stehender Wellen in positiv arbeitenden Photoresists zu unterdrücken, das bei monochromatischer Belichtung und reflektierenden Oberflächen ein ständiges Problem ist. Das Grundverfahren umfaßt eine Wärmebehandlung, die nach der Belichtung, aber noch vor dem Entwickeln durchgeführt wird. Eine typische Folge von Verfahrensschritten besteht beispielsweise aus einer Vortrocknung bei etwa 50 bis 70°C, Belichtung, einer Wärmebehandlung nach der Belichtung bei bis zu 110°C und anschließender Entwicklung.

Von E. J. Walker wurde in "IEEE Transactions on Electronic Devices", Bd. ED 22, Nr. 7, S. 464, Juli 1974, erstmals darauf hingewiesen, daß durch eine zwischen Belichtung und Entwicklung erfolgende Wärmebehandlung positiv arbeitender Photoresists die Druckeigenschaften verbessert und das Auftreten von Interferenzbildern, die als Folge monochromatischer Belichtung reflektierender Oberflächen erscheinen, reduziert werden können. Das vorgeschlagene Verfahren sah die Diffusion der nicht belichteten lichtempfindlichen Verbindung von Stellen auslöschender Interferenz, wo die Konzentration an lichtempfindlicher Verbindung ein örtliches Maximum aufweist, zu Stellen verstärkender Interferenz, wo die Konzentration an lichtempfindlicher Verbindung ein örtliches Minimum aufweist, vor. Örtlich einheitliche Löslichkeitsraten des Photoresists im Entwickler wurden beobachtet, wenn die Temperaturen für die Wärmebehandlung nach dem Belichten über den Temperaturen für die Vortrocknung lagen. Drucktechnische Verbesserungen wurden hinsichtlich der unter praxisnahen Bedingungen erzielbaren Auflösung und des Verarbeitungsspielraumes d. h. der Beziehung zwischen Linienbreite und Belichtungsenergie, festgestellt. Nachteilig an diesem Verfahren war jedoch die nicht ausreichende Lichtempfindlichkeit und Kantensteilheit.

Walker benutzte eine Temperatur von 90°C für die Vortrocknung und eine Temperatur von 100°C für die im Anschluß an die Belichtung durchgeführte Wärmebehandlung. Ein modifiziertes Verfahren, bei dem sich an eine Vortrocknung bei 50 bis 70°C eine Wärmebehandlung bei 90°C anschloß, wurde später von Dill und Shaw in "IBM J. Res. Develop.", Mai 1977, S. 210, und von Arnold und Levison in "Proceedings of Symposium Kodak Interface" 1983, San Diego, Ca., S. 80, beschrieben. Die niedrigere Temperatur für die Wärmebehandlung nach der Belichtung trug dazu bei, daß der ungünstige Einfluß auf die Lichtempfindlichkeit und Kantensteilheit im wesentlichen ausgeschaltet wurde, während bei der niedrigeren Temperatur für die Vortrocknung die von Walker festgestellten Vorteile erhalten blieben.

Es ist auch ein Verfahren zum Ablösen von positivem Photolack von einem Substrat bekannt (DE-C-2 447 225 entsprechend US-A-4 015 986), der ein Novolakharz enthält, bei dem eine wäßrige Lösung von Kalium- oder Ammoniumpermanganat und Phosphorsäure verwendet wird. Dabei wird das Entwickeln so durchgeführt, daß selektiv belichtete und anschließend bei Temperaturen zwischen 130 und 210°C innerhalb von 30 Minuten gehärtete Schichten so lange in die Lösung gestellt werden, bis die belichteten Bereiche abgelöst sind.

Nachteilig hieran ist, daß eine solche Entwicklerlösung nicht gut lagerfähig ist und daß die so gehärteten Schichten noch nicht höchsten Ansprüchen, wie gutem Kontrast und guter Auflösung genügen.

Aus IBM Technical Disclosure Bulletin, Band 13, (1970), Nr. 2, Seite 530, ist bekannt, bei der Herstellung von Photoresist-Strukturen nach der Belichtung eine Wärmebehandlung durchzuführen. Hierzu sind jedoch 5 bis 8 Minuten bei Temperaturen in einem engen Bereich von 95 bis 105°C erforderlich.

Aus Solid State Technology, Band 26 (1983), Nr. 8, Seiten 211 bis 217, sind Ausheizeffekte für Photoresist-Strukturen bekannt, für die zunächst ein Vortrocknungsprozeß bei Temperaturen von 50 bis 120°C vorgesehen ist. Die auf die Belichtung folgende Nacherhitzung wird bei 110°C durchgeführt.

Die DE-A-2 461 912 beschreibt ein Verfahren zur Bildausbildung, bei dem die lichtempfindliche Schicht gleichzeitig mit der bildweisen Belichtung oder nach der bildweisen Belichtung erhitzt wird, und wobei mindestens die unbelichteten Bereiche der lichtempfindlichen Schicht mit aktiver Strahlung bestrahlt werden sowie die lichtempfindliche Schicht unter Entfernen der unbelichteten Bereiche entwickelt wird.

Schließlich ist aus EP-A-0 021 719 die Herstellung von Negativ-Resist-Strukturen bekannt, wobei das Diazofilmmaterial mit Elektronenstrahlen bildweise bestrahlt und einer Wärmebehandlung unterworfen wird, dann der Film ganzflächig mit UV-Strahlung bestrahlt, entwickelt und nochmals einer Wärmebehandlung unterzogen wird.

Die bekannten Vefahren mit den einzelnen Verfahrensschritten führen noch nicht zu Photoresist-Strukturen, die hohen Ansprüchen gerecht werden, wie thermische Stabilität des erzeugten Bildes und z. B. ein relativ großer Verarbeitungsspielraum in den einzelnen Stufen.

Es war Aufgabe der vorliegenden Erfindung ein Verfahren zum Herstellen von Photoresist-Strukturen zu schaffen, bei dem ein positiv arbeitendes Kopiermaterial verwendet wird. Die Strukturen sollten hierdurch einen erhöhten Kontrast bei möglichst verbesserter Auflösung und höherer Wärmebeständigkeit aufweisen.

Die Lösung dieser Aufgabe besteht in einem Verfahren zum Herstellen von Photoresist-Strukturen aus positiv arbeitenden Kopiermaterialien, bestehend im wesentlichen aus einem Träger und einem aufgebrachten lichtempfindlichen Gemisch aus wasserlöslichem, in wäßrig-alkalischen Lösungen löslichem oder zumindest quellbarem Bindemittel, Naphthochinondiazid und Lösemittel, durch die Kombination der einzelnen Verfahrensschritte:

a) Vortrocknen des Gemisches auf dem Träger bei einer Temperatur im Bereich zwischen 20 und 100 °C,

b) bildmäßiges Belichten mit aktinischer Strahlung,

c) Ausheizen der belichteten Schicht bei einer Temperatur im Bereich zwischen etwa 120 und 160°C innerhalb von etwa 15 bis 90 Sekunden und
d) Entwickeln durch Entfernen der belichteten Stellen mit einer wäßrig-alkalischen Lösung.

Vorzugsweise nimmt man das Vortrocknen bei einer Temperatur im Bereich zwischen etwa 50 und 95°C, insbesondere zwischen 70 und 95°C, in einer Zeit von etwa drei Minuten, bevorzugt 60 Sekunden vor. Das Ausheizen führt man vorzugsweise bei einer Temperatur im Bereich zwischen etwa 130 und 160°C, insbesondere zwischen etwa 140 und 160°C, in einer Zeit von etwa 30 bis 90 Sekunden durch. Ganz besonders vorteilhaft ist ein Verfahren, bei dem man das Vortrocknen bei einer Temperatur im Bereich zwischen etwa 85 und 95°C innerhalb von etwa 60 Sekunden und das Ausheizen bei einer Temperatur im Bereich zwischen etwa 140 und 160°C innerhalb von etwa 30 bis 90 Sekunden durchführt.

Erfindungsgemäß wird das Ausheizen nach der Belichtung des positiv arbeitenden Kopiermaterials bei einer wesentlich höheren Temperatur als üblich vorgenommen. Es hat sich überraschend gezeigt, daß eine im Anschluß an die Belichtung durchgeführte Wärmebehandlung bei höherer Temperatur eine Anzahl von Vorteilen mit sich bringt, wie eine Erhöhung des Kontrastes, des Verarbeitungsspielraumes und der unter Praxisbedingungen erzielbaren Auflösung. Weiterhin hat sich gezeigt, daß die Wärmebeständigkeit der entwickelten Photoresist-Struktur bis zu einer Temperatur, die mindestens der Temperatur entspricht, bei der die Ausheizung im Anschluß an die Belichtung durchgeführt wird, gegeben ist. Schließlich resultiert erfindungsgemäß eine bessere Kontrolle über stehende Wellen und andere Reflektionserscheinungen. Es konnte auch eine fast völlige Vermeidung von Resisthäutchenbildung und Rückstandsproblemen festgestellt werden, die sonst bei Metallionen enthaltenden Entwicklern üblich sind.

Für die Herstellung der erfindungsgemäßen Photoresist-Struktur wird zunächst ein geeigneter Träger mit einem lichtempfindlichen Gemisch beschichtet und die Schicht vorgetrocknet. In dem Gemisch sind ein in wäßrigen Alkalien lösliches harzartiges Bindemittel, bevorzugt ein Novolak und eine lichtempfindliche Verbindung auf o-Naphthochinondiazid-Basis enthalten.

Die Herstellung von Novolakharzen, die als Bindemittel für die Herstellung lichtempfindlicher Gemische geeignet sind, ist bekannt. Sie wird beispielsweise von A. Knop und W. Scheib in "Chemistry and Application of Phenolic Resins", New York, Springer-Verlag, 1979, Kap. 4, beschrieben. Als Bindemittel werden in dem erfindungsgemäßen Verfahren dementsprechend gegebenenfalls substituierte Phenol-Formaldehyd-Novolakharze verwendet. Auch die Verwendung von o-Chinondiaziden ist dem Fachmann bekannt und beispielsweise beschrieben in J. Kosar, "Light Sensitive Systems", New York, John Wiley & Sons, 1965, Kap. 7.4.

Diese lichtempfindlichen Verbindungen, die auch einen Bestandteil der erfindungsgemäß eingesetzten Gemische bilden, werden vorzugsweise aus der Gruppe der lichtempfindlichen Verbindungen auf der Basis substituierter o-Naphthochinondiazide ausgewählt, wie sie üblicherweise in den Rezepturen für positiv arbeitende Photoresistgemische verwendet werden. Geeignete Verbindungen dieser Art sind beispielsweise in den US-A-2 797 213, 3 106 465, 3 148 983, 3 130 047, 3 201 329, 3 785 825 und 3 802 885 beschrieben. Dazu gehören beispielsweise mit Phenolverbindungen, wie zum Beispiel Hydroxybenzophenonen, insbesondere Trihydroxybenzophenon und vor allem 2,3,4-Trihydroxybenzophenon, kondensiertes Naphthochinon-(1,2)-diazid-(2)-5-sulfonylchlorid.

Bevorzugt verwendet man in dem lichtempfindlichen Gemisch als o-Naphthochinondiazid Reaktionsprodukte aus einem o-Naphthochinondiazidsulfonylchlorid und Hydroxy- bzw. Polyhydroxy-aryl-, Aminoaryl- bzw. Polyamino-aryl-Verbindungen.

Das lichtempfindliche Gemisch wird hergestellt durch Mischen der Bestandteile in einem geeigneten Lösemittelgemisch, wobei in einer bevorzugten Ausführungsform der Feststoffanteil des Gemisches, d. h. der Novolak- und Diazidanteil bei etwa 15 bis 99 % an Novolakharz und etwa 1 bis 85 % an Diazid liegt. Insbesondere beträgt der Anteil an Novolakharz etwa 50 bis 90 Gewichtsprozent, ganz besonders bevorzugt etwa 65 bis 85 Gewichtsprozent, jeweils bezogen auf den Feststoffgehalt des Gemischs. Der Diazidanteil beträgt insbesondere etwa 10 bis 50 Gewichtsprozent, ganz besonders bevorzugt etwa 15 bis 35 Gewichtsprozent, jeweils bezogen auf den Feststoffgehalt des Gemisches.

Bei der Herstellung des Gemisches werden der Novolak und das Diazid mit geeigneten Lösemitteln, wie zum Beispiel Xylol, Butylacetat, Ethylenglykolmonoethyletheracetat, Propylenglykolmononiederalkylether oder Propylenglykolmononiederalkyletheracetat allein oder in Mischung gemischt. Vor dem Auftragen der Lösung auf den Träger können dem lichtempfindlichen Gemisch aus Novolakharz, lichtempfindlicher Verbindung und Lösemittel noch Zusätze wie Farbstoffe, Mittel zur Verhinderung von Streifenbildung, Verlaufshilfsmittel, Weichmacher, Haftvermittler, die Lichtempfindlichkeit steigernde Mittel und Netzmittel, zum Beispiel nichtionische Netzmittel, zugesetzt werden.

Beispiele für erfindungsgemäß geeignete Farbstoffzusätze sind Methylviolett 2B (C.I. 42 535), Kristallviolett (C.I. 42 555), Malachitgrün (C.I. 42 000), Viktoriablau B (C.I. 44 045) und Neutralrot (C.I. 50 040). Sie können in einer Menge von 0,1 bis 10 Gewichtsprozent, bezogen auf das Gesamtgewicht von Novolak und lichtempfindlicher Verbindung zugesetzt werden. Die Farbstoffzusätze tragen zu einer besseren Bildauflösung bei, da eine Rückstreuung des Lichts vom Träger verhindert wird.

Als Verlaufshilfsmittel können zum Beispiel übliche Netzmittel verwendet werden.

Mittel zur Verhinderung von Streifenbildung können in einer Menge bis zu 5 Gewichtsprozent, bezogen auf das Gesamtgewicht von Novolak und lichtempfindlicher Verbindung, zugesetzt werden.

Geeignete Weichmacher sind beispielsweise Phosphorsäuretri-(β-chlorethyl)ester, Stearinsäure, Dicampher, Polypropylen, Acetalharze, Phenoxyharze und Alkydharze. Sie werden in einer Menge von 1 bis 10

4

Gewichtsprozent, bezogen auf das Gesamtgewicht von Novolak und lichtempfindlicher Verbindung, zugesetzt. Durch den Zusatz von Weichmachern werden die Beschichtungseigenschaften des Gemisches verbessert, so daß es möglich ist, eine glatte Schicht gleichmäßiger Dicke zu erzeugen.

Zu den geeigneten Haftvermittlern zählen β-(3,4-Epoxycyclohexyl)-ethyltrimethoxysilan, Vinyltrichlorsilan und γ-Aminopropyltriethoxysilan. Sie werden in einer Menge bis zu 4 Gewichtsprozent, bezogen auf das Gesamtgewicht von Novolak und lichtempfindlicher Verbindung, zugesetzt.

Zur Erhöhung der Lichtempfindlichkeit können beispielsweise Pikrinsäure, Nicotinsäure oder Nitrozimtsäure in einer Menge von bis zu 20 Gewichtsprozent, bezogen auf das Gesamtgewicht von Novolak und lichtempfindliche Verbindung, zugesetzt werden. Durch diese Stoffe wird die Löslichkeit der lichtempfindlichen Schicht sowohl an den belichteten als auch an den unbelichteten Stellen erhöht.

Diese Stoffe werden daher in den Fällen beigemischt, wo vor allem auf eine zügige Entwicklung Wert gelegt wird, auch wenn dies auf Kosten des Bildkontrastes geht. Diese Einbuße an Kontrast rührt daher, daß nach dem Zusatz von die Lichtempfindlichkeit steigernden Mitteln der Entwickler nicht nur die belichteten Stellen der lichtempfindlichen Schicht schneller löst, sondern daß auch an den unbelichteten Stellen ein erhöhter Schichtverlust eintritt.

Der Anteil der für die Beschichtungslösung verwendeten Lösemittel am Gesamtgemisch kann bis zu 95 Gewichtsprozent, bezogen auf den Gesamtfeststoffgehalt, betragen.

Zu den nichtionischen Netzmitteln, die eingesetzt werden können, zählen zum Beispiel Nonylphenoxypoly(ethylenoxy)ethanol, Octylphenoxy(ethylenoxy)ethanol und Dinonylphenoxypoly(ethylenoxy)ethanol. Sie können in einer Menge bis zu 10 Gewichtsprozent, bezogen auf das Gesamtgewicht von Novolak und lichtempfindlicher Verbindung eingesetzt werden.

Die fertig zubereitete lichtempfindliche Lösung wird mit Hilfe gebräuchlicher Verfahren durch Tauchen, Sprühen oder Schleudern auf einen geeigneten Träger aufgebracht. Bei einem Schleuderverfahren wird beispielsweise der Feststoffgehalt der Lösung auf einen bestimmten Prozentsatz eingestellt, um in Abhängigkeit von der verwendeten Schleudervorrichtung und der Aufschleuderzeit die jeweils gewünschte Schichtdicke zu erzielen.

Als Materialien für den Träger oder darauf aufgebrachte Oberflächen kommen zum Beispiel Silicium, Aluminium oder polymere Harze, Siliciumdioxid, dotiertes Siliciumdioxid, Siliciumnitrid, Tantal, Kupfer, Polysilicium, Keramik und Aluminium-Kupfer-Legierungen in Frage.

Kopierschichten der beschriebenen Art eignen sich besonders gut zum Aufbringen auf Siliciumwafer mit thermisch erzeugten Siliciumdioxidschichten, wie sie bei der Produktion von Mikroprozessoren und anderen Mikroschaltelementen verwendet werden. Es kann auch ein Träger aus Aluminium mit einer Aluminiumoxidschicht verwendet werden.

Nach dem Auftragen der Lösung auf den Träger wird der Träger einer Temperaturbehandlung bzw. Vortrocknung bei etwa 20°C bis 100°C unterzogen. Diese Temperaturbehandlung erfolgt, um Restlösemittelkonzentration in der Sicht zu verringern und zu kontrollieren, ohne daß es dabei zu einer nennenswerten thermischen Zersetzung der lichtempfindlichen Verbindung kommt. Es wird im allgemeinen angestrebt, den Gehalt an Lösemitteln auf ein Minimum zu senken, und diese erste Wärmebehandlung wird daher so lange fortgeführt, bis die Lösemittel praktisch vollständig verdampft sind und eine dünne Schicht aus lichtempfindlichem Trockengemisch, denen Dicke etwa 1 μm Temperatur bei dieser Behandlung zwischen etwa 50 und 95°C, insbesondere zwischen etwa 70 und 95°C. Die Vortrocknung ist dann beendet, wenn sich der Lösemittelanteil nicht mehr nennenswert verringert. Die Wahl der jeweiligen Temperatur und Zeitdauer hängt von den vom Anwender gewünschten Resisteigenschaften, der verwendeten Ausrüstung und den für kommerzielle Zwecke erwünschten Beschichtungszeiten ab.

Bei einer Behandlung mit Hilfe von Heizplatten, sogenannten "Hot Plates", ist eine Dauer von bis zu 3 Minuten, bevorzugt bis zu 60 Sekunden, wirtschaftlich sinnvoll. In einem der Beispiele wird die Behandlung 30 Sekunden bei 90°C durchgeführt. Der beschichtete Träger wird anschließend mit aktinischer Strahlung, insbesondere mit UV-Strahlung, durch geeignete Masken, Negative, Schablonen usw., bildmäßig belichtet.

Danach findet eine sich an die Belichtung anschließende zweite Wärmebehandlung, die Ausheizung bei einer Temperatur zwischen etwa 120 und 160°C, bevorzugt etwa 130 bis 160°C, insbesondere 140 bis 160°C, und ganz besonders bevorzugt zwischen 140 bis 155°C statt. Die Behandlung wird mit einem Heizplattensystem durchgeführt und dauert etwa 15 bis 90 Sekunden, vorzugsweise etwa 30 bis 90 Sekunden.

Die für die Vortrocknung und die Ausheizung gewählten Temperaturen und deren Behandlungsdauer werden aufgrund der vom Anwender gewünschten Eigenschaften auf den jeweils am besten geeigneten Wert eingestellt. Je tiefer die Temperatur für die Vortrocknung innerhalb des angegebenen Bereichs liegt, desto niedriger kann in der Regel auch die Temperatur für das Ausheizen innerhalb des angegebenen Bereichs eingestellt werden. Doch gilt hier ebenfalls, daß der Anwender die Bedingungen in Abhängigkeit von seinen speziellen Erfordernissen optimal aufeinander abstimmen kann und muß. Falls der Anwender beispielsweise wünscht, das Auftreten von durch Streulicht verursachten Defekten auf ein Mindestmaß zu reduzieren, kann er für die Vortrocknung eine Temperatur am unteren Ende des bevorzugten Bereichs und für die Ausheizung eine Temperatur am oberen Ende des bevorzugten Bereichs wählen. Falls der Anwender jedoch zum Beispiel Wert legt auf eine erhöhte Temperaturbeständigkeit der entwickelten Struktur, empfiehlt es sich, für beide Behandlungsschritte jeweils den oberen Temperaturbereich zu wählen. In der Tat kann der Anwender eine Wärmebeständigkeit bis mindestens zu der Temperatur erzielen, bei der die im Anschluß an die Belichtung durchgeführte Ausheizung vorgenommen wurde.

Anschließend werden die beschichteten und belichteten Träger in eine wäßrig-alkalische Entwicklerlösung getaucht. Die Lösung wird vorzugsweise stark bewegt, was zum Beispiel durch Durchblasen von Stickstoff erfolgen kann. Die Träger bleiben so lange in der Entwicklerlösung, bis die lichtempfindliche Schicht an den belichteten Stellen ganz oder doch fast ganz abgelöst ist.

Im Anschluß an die Entwicklung kann noch eine Wärmebehandlung durchgeführt werden, um die Haftung der Schicht und ihre chemische Resistenz gegen Ätzlösungen und andere Substanzen zu erhöhen. Die sich an die Entwicklung anschließende Wärmebehandlung ist beispielsweise eine Behandlung des Trägers und der darauf aufgebrachten Schicht bei Temperaturen unterhalb des Erweichungspunktes der Beschichtung.

Für industrielle Anwendungen, insbesondere bei der Herstellung von Halbleiterbauelementen auf Siliciumträgern mit einer Siliciumdioxidschicht können die entwickelten Träger mit einer gepufferten Lösung auf der Basis einer Flußsäurelösung geätzt werden. Die Bestandteile des erfindungsgemäßen Kopiermaterials sind gegen derartige Ätzlösungen resistent und gewährleisten einen wirksamen Schutz der unbelichteten, beschichteten Stellen des Trägers.

Anhand der folgenden Beispiele sollen die Vorteile des erfindungsgemäßen Verfahrens erläutert werden. Die Erfindung soll nicht auf diese Beispiele und auf die darin angegebenen Bedingungen, Parameter oder Werte beschränkt sein.

## Beispiel 1

Zwei lichtempfindliche Gemische werden aus den folgenden Bestandteilen hergestellt

**Resist A**

**Resist B**

23,8 % Harz
 7,0 % lichtempf. Verb. A
69,2 % Lösemittel

23,8 % Harz
 3,0 % lichtempf. Verb. B
73,2 % Lösemittel

Bei dem Harz handelt es sich um ein Kresol-Formaldehyd-Novolakharz, das erhalten wird durch Kondensation eines Kresolgemischs, das in der Hauptsache aus gleichen Teilen p- und m-Kresol besteht, mit wäßrigem Formaldehyd in einem sauren Kondensationsmedium. Das Kondensationsprodukt hat nach dem Entwässern ein Molekulargewicht von etwa 4 000, was mit Hilfe der Gelpermeationschromatographie bestimmt wurde. Die Viskosität des Harzes beträgt etwa 650 Centistokes (= 650 mm/s), gemessen bei 25°C in einer Ethylenglykolmonoethyletherlösung mit einem Feststoffgehalt von 40 Gewichtsprozent.

Die lichtempfindlichen Verbindungen A und B sind Reaktionsprodukte aus Naphthochinon-(1,2)-diazid-(2)-5-sulfonylchlorid und 2,3,4-Trihydroxybenzophenon. Der durchschnittliche Substitutionsgrad von A beträgt 2, während der durchschnittliche Substitutionsgrad von B etwa 3 beträgt, d.h., A ist ein Gemisch aus mehreren Isomeren, während B eine im wesentlichen reine trisubstituierte Verbindung ist.

Das Lösemittelsystem besteht aus 80 Gewichtsprozent Ethylenglykolmonoethyletheracetat, 10 Gewichtsprozent n-Butylacetat und 10 Gewichtsprozent Xylol.

Zunächst wird das Harz durch Einrühren in das Lösemittelsystem gelöst. Anschließend werden die lichtempfindlichen Verbindungen langsam unter Rühren hinzugefügt und ebenfalls vollständig gelöst.

## Beispiel 2

Zwei als Träger für die Herstellung integrierter Schaltungen geeignete Siliciumwafer werden mit einer haftvermittelnden Schicht aus Hexamethyldisilazan versehen. Danach wird auf jeden Wafer eine 1,8 μm dicke Schicht des Resists A aus Beispiel 1 aufgeschleudert. Beide Wafer werden in einem Umluftschrank 30 Minuten bei 90°C wärmebehandelt. Danach werden sie mit aktinischer Strahlung von 120 mJ/cm$^2$ durch eine Testvorlage zum Prüfen der Auflösung belichtet. Wafer 1 wird anschließend mittels eines Heizplattensystems für 45 Sekunden einer Ausheizung bei 140°C unterworfen. Wafer 2 wird nicht wärmebehandelt. Beide Wafer werden sodann mit einem wäßrig-alkalischen Entwickler, der ein 0,54 N Natriumsilikat-, Natriumphosphat-Gemisch mit einem pH von 12 darstellt, (AZ Developer, Hersteller AZ Photoresist Products Group der American Hoechst Corporation, Somerville, New Jersey, USA) entwickelt.

Die Entwicklungszeit für Wafer 1 beträgt 60 Sekunden, die Entwicklungszeit für Wafer 2 beträgt 30 Sekunden.

Der nach bekanntem Verfahren hergestellte Wafer 2 wird unter einem Rasterelektronenmikroskop (REM) untersucht, und es werden Linienbreiten bis 2 μm festgestellt. Bei 10 000-facher Vergrößerung sind Kantenneigungen von 85° erkennbar. Wafer 1 wird ebenfalls unter dem REM untersucht; auch hier werden Bildteile einer Größe von 2 μm wiedergegeben, und die Kantenneigung der Photoresistlinien beträgt etwa 65°.

Die Wärmebeständigkeit wird folgendermaßen geprüft: Die Wafer werden in einen auf 140°C eingestellten Wärmeschrank gelegt. Nach 30 Minuten werden sie herausgenommen, und die Resistbilder nochmals unter dem REM geprüft, wobei das Vergrößerungsverhältnis und der Neigungswinkel gleich sind wie bei der ersten Messung. Es wird festgestellt, daß die Abmessungen und Steilheit der ursprünglich 2 μm großen Zeichen auf Wafer 2 sich verändert haben. Die Breite der 2 μm-Linien beträgt nun 2,4 bis 2,6 μm. Die Kantensteilheit der Linien erscheint unregelmäßig. Anschließend wird Wafer 1 unter das REM gelegt, und die Abmessungen der 2-μm großen Bildteile werden nachgeprüft. Weder die Abmessungen noch die Kantensteilheit haben sich verändert.

## Beispiel 3

Zwei als Träger für die Herstellung integrierter Schaltungen geeignete Siliciumwafer werden mit einer haftvermittelnden Schicht aus Hexamethyldisilazan versehen. Darauf wird auf jeden Wafer eine 2 μm dicke Schicht des Resists B aus Beispiel 1 mit 4 000 U/min aufgeschleudert.

Beide Wafer werden auf einer Hot Plate bei 90°C 60 Sekunden lang vorgetrocknet. Dann werden sie durch eine Testvorlage mit aktinischer Strahlung von 80 mJ/cm$^2$ belichtet. Wafer 1 wird anschließend mittels eines Heizplattensystems für 45 Sekunden einer Ausheizung unterworfen, während Wafer 2 nicht auf diese Art behandelt wird. Beide Wafer werden sodann mit einem wäßrig-alkalischen Entwickler, der eine 0,15 N Kalium haltige alkalische Lösung darstellt (AZ 421 K, Hersteller AZ Photoresist Products Group der American Hoechst Corporation, Somerville, New Jersey, USA), entwickelt. Die Entwicklungszeit für Wafer 1 beträgt 300 Sekunden, die Entwicklungszeit für Wafer 2 beträgt 60 Sekunden.

Der nach herkömmlichem Verfahren hergestellte Wafer 2 wird unter einem REM untersucht, wobei Linienbreiten bis zu 2 μm gemessen werden. Bei 10 000-facher Vergrößerung ist ein Beugungsmuster auf der Oberfläche des Resists erkennbar, das mehr als die Hälfte der Dicke der Resistschicht durchdringt.

Wafer 1 wird auch unter dem REM untersucht, wobei ebenfalls Bildelemente einer Breite von 2 μm gemessen werden. Es wird festgestellt, daß die klar voneinander abgegrenzten Bildelemente glatte Oberflächen besitzen und daß die bei dem herkömmlichen Verfahren beobachteten Beugungsmuster praktisch nicht auftreten.

Anschließend wird die Wärmebeständigkeit auf die folgende Weise geprüft: Die beiden Wafer 1 und 2 werden in einen Trockenschrank gelegt, dessen Temperatur auf 150°C eingestellt ist. Nach einer Einbrennzeit von 30 Minuten werden die Wafer herausgenommen, und die Resistbilder werden nochmals unter dem REM geprüft, wobei das Vergrößerungsverhältnis und der Neigungswinkel gleich sind wie bei der ersten Messung. Man stellt fest, daß die Abmessungen der ursprünglich 2 μm großen Zeichen auf Wafer 2 sich verändert haben und ihre Breite nun 2,8 μm beträgt. Anschließend wird Wafer 1 unter das REM gelegt, und die Breite der 2-μm-Linien gemessen. Es werden keine Größenveränderungen aufgrund der Wärmebehandlung festgestellt, was bedeutet, daß durch die im Anschluß an die Belichtung durchgeführte Wärmebehandlung bei 150°C die Wärmebeständigkeit verbessert wurde.

## Beispiel 4

Zwei als Träger für die Herstellung integrierter Schaltungen geeignete Siliciumwafer werden mit einer haftvermittelnden Schicht aus Hexamethyldisilizan versehen. Danach wird auf jeden Wafer eine 2 μm dicke Schicht des Resists B aus Beispiel 1 bei 4 000 U/min aufgeschleudert. Beide Wafer werden in einem Umluftschrank bei 90°C 30 Minuten lang wärmebehandelt. Dann werden sie durch eine Testvorlage mit aktinischer Strahlung belichtet. Wafer 1 wird anschließend mittels eines Heizplattensystems für 45 Sekunden einer Ausheizung bei 150°C unterworfen, während Wafer 2 diese Behandlung nicht erfährt. Beide Wafer werden sodann mit einem von Metallionen freien Tetramethylammoniumhydroxid enthaltenden wäßrig-alkalischen Entwickler entwickelt (AZ 427 MIF Developer, Hersteller AZ Photoresist Products Group der American Hoechst Corporation, Somerville, New Jersey, USA).

Die Verfahrensbedingungen und Eigenschaften der Resists sind in der folgenden Tabelle zusammengestellt:

|  | Wafer 1 | Wafer 2 |
|---|---|---|
| Entwicklerkonzentration | 0,32 N | 0,27 N |
| Entwicklungszeit (s) | 120 | 180 |
| Lichtempfindlichkeit (mJ/cm$^2$ | 80 | 115 |
| Kontrast | 2,9 | 1,5 |
| Verlust an unbelichtete Resistteilen (nm) | 10 | 80 |

Die obigen Werte zeigen, daß durch die im Anschluß an die Belichtung durchgeführte Ausheizung deutliche Verbesserungen erzielt werden im Hinblick auf die Lichtempfindlichkeit, Bildkontrast und Verlust an unbelichteten Resistteilen. Auch werden bei der Bewertung der Bilder auf Wafer 1 unter dem REM keine Rückstände oder Resisthäutchen festgestellt. Dieses Beispiel zeigt den Prozeßspielraum des Verfahrens im Hinblick auf die Lichtempfindlichkeit und den Bildkontrast. Die Entwicklungszeit ändert sich umgekehrt proportional zur Entwicklerkonzentration.

**Patentansprüche**

1. Verfahren zum Herstellen von Photoresist-Strukturen aus positiv arbeitenden Kopiermaterialien, bestehend im wesentlichen aus einem Träger und einem aufgebrachten lichtempfindlichen Gemisch aus wasserlöslichem, in wäßrig-alkalischen Lösungen löslichem oder zumindest quellbarem Bindemittel, Naphthochinondiazid und Lösemittel, durch

a) Vortrocknen des Gemisches auf dem Träger bei einer Temperatur im Bereich zwischen 20 und 100° C,

b) bildmäßiges Belichten mit aktinischer Strahlung,

c) Ausheizen der belichteten Schicht bei einer Temperatur im Bereich zwischen etwa 120 und 160°C innerhalb von etwa 15 bis 90 Sekunden und

d) Entwickeln durch Entfernen der belichteten Stellen mit einer wäßrig-alkalischen Lösung.

2. Verfahren nach Anspruch 1 dadurch gekennzeichnet, daß man das Vortrocknen bei einer Temperatur im Bereich zwischen etwa 50 und 95°C vornimmt.

3. Verfahren nach Anspruch 1 oder 2, dadurch gekennzeichnet, daß man das Vortrocknen innerhalb von etwa 60 Sekunden vornimmt.

4. Verfahren nach Anspruch 1 dadurch gekennzeichnet, daß man das Ausheizen bei einer Temperatur im Bereich zwischen etwa 130 und 160°C vornimmt.

5. Verfahren nach Anspruch 1 oder 4, dadurch gekennzeichnet, daß man das Ausheizen innerhalb von etwa 30 bis 90 Sekunden vornimmt.

6. Verfahren nach Ansprüchen 1 bis 5, dadurch gekennzeichnet, daß man das Vortrocknen bei einer Temperatur im Bereich zwischen etwa 85 und 95° C innerhalb von etwa 60 Sekunden und das Ausheizen bei einer Temperatur im Bereich zwischen etwa 140 und 160°C innerhalb von etwa 30 bis 90 Sekunden vornimmt.

7. Verfahren nach Anspruch 1, dadurch gekennzeichnet, daß man ein lichtempfindliches Gemisch verwendet, das zusätzlich Farbstoffe, Mittel zur Verhinderung von Streifenbildung, Verlaufshilfsmittel, Weichmacher, Haftvermittler, die Lichtempfindlichkeit steigernde Mittel und Netzmittel enthält.

8. Verfahren nach Anspruch 1, dadurch gekennzeichnet, daß man ein lichtempfindliches Gemisch verwendet, das als Naphthochinondiazid Reaktionsprodukte aus einem Diazidsulfonylchlorid und Hydroxy- bzw. Polyhydroxy-aryl-, Amino-aryl- bzw. Polyamino-aryl-Verbindungen enthält.

9. Verfahren nach Anspruch 8, dadurch gekennzeichnet, daß ein Kondensationsprodukt aus Naphthochinon-(1,2)-diazid-(2)-5-sulfonylchlorid und 2,3,4-Trihydroxybenzophenon verwendet.

10. Verfahren nach Anspruch 1, dadurch gekennzeichnet, daß man als Träger Materialien oder Materialien mit Oberflächen aus Silicium, Aluminium, polymeren Harzen, Siliciumdioxid, dotiertes Siliciumdioxid, Siliciumnitrid, Tantal, Kupfer, Polysilicium, Keramik oder Aluminium-Kupfer-Legierungen, verwendet.

11. Verfahren nach Anspruch 1 dadurch gekennzeichnet, daß man als Bindemittel ein gegebenenfalls substituiertes Phenol-Formaldehyd-Novolakharz verwendet.

12. Verfahren nach Anspruch 1, dadurch gekennzeichnet, daß man als Lösemittel Xylol, Butylacetat, Ethylenglykolmonoethyletheracetat, Propylenglykolmononiederalkylether oder Propylenglykolmononiederalkyletheracetat allein oder in Mischung verwendet.

**Revendications**

1. Procédé pour la production de structures de photoresists à partir de matériau de copie travaillant en positif, consistant essentiellement en un support et en une composition photosensible, appliquée sur celui-ci, à base de liant insoluble dans l'eau, soluble ou au moins susceptible de gonfler dans des solutions aqueuses alcalines, napthoquinonediazide et solvant, par:

a) pré-séchage de la composition sur le support, à une température dans la plage comprise entre 20 et 100° C,

b) exposition selon l'image au moyen d'un rayonnement actinique,

c) chauffage de la couche exposée, à une température dans la plage comprise entre environ 120 et 160°C, en l'espace d'environ 15 à 90 secondes, et

d) développement par élimination, au moyen d'une solution aqueuse alcaline, des zones exposées.

2. Procédé selon la revendication 1, caractérisé en ce que l'on effectue le pré-séchage à une température dans la plage comprise entre environ 50 et 95°C.

3. Procédé selon la revendication 1 ou 2, caractérisé en ce que l'on effectue le pré-séchage en l'espace d'environ 60 secondes.

4. Procédé selon la revendication 1, caractérisé en ce que l'on effectue le chauffage à une température dans la plage comprise entre environ 130 et 160°C.

5. Procédé selon la revendication 4, caractérisé en ce que l'on effectue le chauffage en l'espace d'environ 30 à 90 secondes.

6. Procédé selon les revendications 1 à 5, caractérisé en ce que l'on effectue le pré-séchage à une température dans la plage comprise entre 85 et 95°C, en l'espace d'environ 60 secondes, et le chauffage à une température dans la plage comprise entre environ 140 et 160°C, en l'espace d'environ 30 à 90 secondes.

7. Procédé selon la revendication 1, caractérisé en ce que l'on utilise une composition photosensible qui contient en outre des colorants, des agents pour empêcher la formation de stries, des agents d'étalement, des

plastifiants, des agents favorisant l'adhérence, des agents augmentant la photosensibilité et des agents mouillants.

8. Procédé selon la revendication 1, caractérisé en ce que l'on utilise une composition photosensible qui contient, en tant que naphtoquinonediazide, des produits de réaction obtenus à partir d'un chlorure de diazidesulfonyle et des composés hydroxy- ou polyhydroxy-aryle, amino-aryle ou polyamino-aryle.

9. Procédé selon la revendication 8, caractérisé en ce que l'on utilise un produit de condensation obtenu à partir de chlorure de naphtoquinone-(1,2)-diazide-(2)-5-sulfonyle et de 2,3,4-trihydroxybenzophénone.

10. Procédé selon la revendication 1, caractérisé en ce que l'on utilise, en tant que support, des matériaux en ou des matériaux à surface de silicium, aluminium, résines polymères, bioxyde de silicium, bioxyde de silicium dopé, nitrure de silicium, tantale, cuivre, polysilicium, céramique ou alliages aluminium-cuivre.

11. Procédé selon la revendication 1, caractérisé en ce que l'on utilise en tant que liant une résine Novolaque phénol-formaldéhyde éventuellement substituée.

12. Procédé selon la revendication 1, caractérisé en ce que l'on utilise en tant que solvant le xylène, l'acétate de butyle, l'acétate d'éther monoéthylique d'éthylèneglycol, un éther monoalkylique inférieur de propylèneglycol ou un acétate d'éther monoalkylique inférieur de propylèneglycol, seuls ou en mélange.

## Claims

1. Process for the production of photoresist structures from positive-working copy materials, essentially comprising a substrate and an applied, photosensitive mixture of a binder which is soluble in water and soluble or at least swellable in aqueous-alkaline solutions, and diazonaphthoquinone and solvent, by
   a) pre-drying the mixture on the substrate at a temperature in the range between 20 and 100°C,
   b) exposing the material imagewise with actinic radiation,
   c) heating the exposed coating at a temperature in the range between about 120 and 160°C within about 15 to 90 seconds, and
   d) developing the material by removing the exposed areas using an aqueous-alkaline solution.

2. Process according to claim 1, characterized in that the pre-drying is carried out at a temperature in the range between about 50 and 95°C.

3. Process according to claim 1 or 2, characterized in that the pre-drying is carried out within about 60 seconds.

4. Process according to claim 1, characterized in that the heating is carried out at a temperature in the range between about 130 and 160°C.

5. Process according to claim 1 or 4, characterized in that the heating is carried out within about 30 to 90 seconds.

6. Process according to claims 1 to 5, characterized in that the pre-drying is carried out at a temperature in the range between about 85 and 95°C within about 60 seconds and the heating is carried out at a temperature in the range between about 140 and 160°C within about 30 to 90 seconds.

7. Process according to claim 1, characterized in that a photosensitive mixture is used which additionally contains dyes, agents for preventing streaking, flow auxiliaries, plasticizers, adhesion promoters, photospeed enhancers and wetting agents.

8. Process according to Claim 1, characterized in that a photosensitive mixture is used which contains, as the naphthoquinonediazide, products of the reaction of a diazidosulphonyl chloride and hydroxy- or polyhydr-oxyaryl, amino-aryl or polyamino-aryl compounds.

9. Process according to claim 8, characterized in that the product of the condensation of 1,2-naphthoquinone-2-diazide-5-sulphonyl chloride and 2,3,4-trihydroxybenzophenone is used.

10. Process according to claim 1, characterized in that the substrates used are materials comprising, or materials with surfaces comprising, silicon, aluminium, polymeric resins, silicon dioxide, doped silicon dioxide, silicon nitride, tantalum, copper, polysilicon, ceramics or aluminium-copper alloys.

11. Process according to claim 1, characterized in that the binder used is an optionally substituted phenolformaldehyde novolak resin.

12. Process according to Claim 1, characterized in that the solvent used is xylene, butyl acetate, ethylene glycol monoethyl ether acetate, propylene glycol mono(lower alkyl) ether or propylene glycol mono(lower alkyl) ether acetate, alone or in a mixture.